Europäisches Patentamt

European Patent Office

Office européen des brevets

(11) Veröffentlichungsnummer: **0 494 436 A2**

# EUROPÄISCHE PATENTANMELDUNG

(21) Anmeldenummer: **91122136.4**

(51) Int. Cl.⁵: **G01R  31/318**

(22) Anmeldetag: **23.12.91**

(30) Priorität: **11.01.91 DE 4100634**

(43) Veröffentlichungstag der Anmeldung:
**15.07.92 Patentblatt  92/29**

(84) Benannte Vertragsstaaten:
**DE FR GB IT**

(71) Anmelder: **ATG ELECTRONIC GmbH**
**Zum Schlag 3**
**W-6980 Wertheim-Reicholzheim(DE)**

(72) Erfinder: **Prokopp, Manfred**
**Am Felder 27**
**W-6980 Wertheim-Reicholzheim(DE)**

(74) Vertreter: **Grosse, Rainer, Dipl.-Ing. et al**
**Gleiss & Grosse Patentanwaltskanzlei**
**Silberburgstrasse 187**
**W-7000 Stuttgart 1(DE)**

(54) **Prüfvorrichtung.**

(57)  Die Erfindung betrifft eine Prüfvorrichtung, insbesondere für einen Funktionstest oder In-Circuit-Test von elektronischen Schaltungen (Prüflingen), insbesondere bestückten Leiterplatten, mit einer Vielzahl von unterschiedliche Prüfspannungen beziehungsweise Prüfpotentiale aufweisenden Prüfkanälen, die mit Prüfpunkten des Prüflings über Schalteinrichtungen verbindbar sind, wobei die Schalteinrichtungen (3) Mikro-Relais (5) aufweisen, deren einzelne Schaltpole (4, 10) mit den Prüfkanälen (7) und deren jedem Prüfkanal (7) zugehörige, gemeinsame Schaltpole (6, 9) über integrierte Anschlußbahnen mit im Raster angeordneten Kontakten (P; pads) eines Grundkontaktfelds (20) verbunden sind.

Fig. 3

EP 0 494 436 A2

Die Erfindung betrifft eine Prüfvorrichtung, insbesondere für einen Funktionstest oder In-Circuit-Test in elektronischen Schaltungen (Prüfling), insbesondere bestückten Leiterplatten, mit einer Vielzahl von unterschiedliche Prüfspannungen bzw. Prüfpotentiale aufweisende Prüfkanäle, die mit Prüfpunkten des Prüflings über Schalteinrichtungen verbindbar sind.

Prüfvorrichtungen der eingangs genannten Art sind bekannt. Mit ihnen können zum Beispiel Fertigungsfehler und/oder Funktionsmängel von elektronischen Baugruppen diagnostiziert werden. Bei einem sogenannten Funktionstest wird die gesamte elektronische Schaltung beziehungsweise ein abgrenzbarer Funktionsblock überprüft. Mit einem In-Circuit-Test ist die Funktion bestimmter Bausteine, also Bauteile oder Baugruppen der gesamten Schaltung überprüfbar. Der Prüfling wird bei den bekannten Prüfvorrichtungen mittels Unterdruck gehalten. Die Kontaktierung zu seinen Prüfpunkten erfolgt vorzugsweise mittels Federstiften, die in individuell entsprechend dem Prüfpunktmuster des Prüflings gebohrten Adapterkörpern gehalten und über flexible elektrische Leitungen mit der Prüfschaltung verbunden sind. Jede elektrische Leitung stellt einen sogenannten Prüfkanal dar, über den ein Prüfsignal zugeführt beziehungsweise abgenommen werden kann. Bei den zugeführten Prüfsignalen kann es sich um eine Prüfspannung beziehungsweise ein Prüfpotential einer Vielzahl von zur Verfügung stehender unterschiedlicher Prüfspannungen beziehungsweise Prüfpotentiale handeln. Damit wird es möglich, den einzelnen Prüfpunkten des Prüflings individuell Testgrößen und/oder Versorgungsgrößen zuzuführen. Die Prüfspannungen beziehungsweise Prüfpotentiale werden von Prüfgeneratoren gebildet. Diese können beispielsweise Gleichspannungen, Wechselspannungen, Hochfrequenzsignale, statische Größen, dynamische Größen, Spannungen oder Ströme usw. liefern. Über die Prüfkanäle können auch Signale empfangen, insbesondere gemessen werden, um eine Messung am Prüfling durchführen. Da die Möglichkeit besteht, jeden Prüfpunkt mit jedem Prüfkanal zu verbinden, sind von den Schalteinrichtungen komplexe Schaltkonfigurationen zu realisieren. Dies führt zu sehr großen Baugruppen mit entsprechend umfangreicher Verdrahtung, so daß ein hoher Kosten- und Raumbedarf vorliegt. Ein besonders kritischer Punkt ist auch die elektromagnetische Verträglichkeit (EMV), das heißt, die Abschirmung gegenüber elektromagnetischer Einstrahlung sowie unerwünschtem Übersprechen.

Der Erfindung liegt daher die Aufgabe zugrunde, eine Prüfvorrichtung der eingangs genannten Art zu schaffen, die einfach aufgebaut und funktionssicher ist, sowie nur einen geringen Raumbedarf hat.

Diese Aufgabe wird erfindungsgemäß dadurch gelöst, daß die Schalteinrichtung Mikro-Relais aufweist, deren einzelne Schaltpole mit den Prüfkanälen und deren zu jedem Prüfkanal zugehörige, gemeinsame Schaltpole über integrierte Anschlußbahnen mit im Raster angeordneten Kontakten eines Grundkontaktfelds verbunden sind. Durch diese erfindungsgemäße Ausbildung entfällt der bei den Prüfvorrichtungen des Standes der Technik erfolgende Verdrahtungsaufwand. Dies ist möglich, weil als Schalteinrichtungen Mikro-Relais zum Einsatz kommen, die direkt über integrierte Anschlußbahnen der Platinen der Prüfvorrichtung angeschlossen werden können. Damit lassen sich die Mikro-Relais in unmittelbarer Nähe des Grundkontaktfelds anordnen, so daß direkt zu den Kontakten verlaufende elektrische Verbindungen ohne großräumige Kabelschleifen - wie das bei den herkömmlichen Anlagen der Fall ist - ausgebildet werden können. Da die Mikro-Relais nur einen außerordentlich kleinen Raumbedarf haben, läßt sich die erfindungsgemäße Prüfvorrichtung wesentlich gegenüber den bekannten Anordnungen verkleinern. Unter "Mikro-Relais" sind im Zuge dieser Anmeldung mikromechanisch aufgebaute Relais zu verstehen. Durch den Wegfall von aufwendig herzustellenden Verdrahtungen/Verbindungen sowie den damit im Zusammenhang stehenden Montage- und Anschlußkosten ist die erfindungsgemäße Prüfvorrichtung kostengünstig herstellbar. Die integrierten Anschlußbahnen verlaufen entlang genau definierter, reproduzierbarer Wege, so daß sich hohe Anforderungen an die elektromagnetische Verträglichkeit erfüllen lassen. Die Mikro-Relais gewährleisten eine galvanische Entkopplung; dies führt zu genau definierten Zuständen. Bekannte Lösungen, die anstelle von Relais Transistoren oder andere Halbleiterschalter einsetzen, haben demgegenüber stets den Nachteil, daß der Steuerkreis den Hauptstromkreis beeinflußt, ein relativ großer Widerstand im leitenden Zustand besteht und im gesperrten Zustand ein geringfügiger Stromfluß erhalten bleibt.

Der Platzbedarf läßt sich nochmals verringern, wenn die Mikro-Relais als Mikro-Relais-Umschalter ausgebildet werden. Der gemeinsame Schaltpol eines derartigen Mikro-Relais-Umschalters ist mit dem entsprechenden Kontakt des Grundkontaktfeldes verbunden. Die von den Prüfgeneratoren gelieferten Signale werden den einzelnen Schaltpolen des Mikro-Relais-Umschalters zugeführt. Je nach Umschalterstellung läßt sich dann der jeweils ausgewählte Prüfgenerator mit dem Kontakt verbinden. Sollte die Anzahl der Schaltstellungen des Mikro-Relais-Umschalters kleiner als die Zahl der Prüfgeneratoren sein, so können auch mehrere Mikro-Relais-Umschalter mit ihrem gemeinsamen Schaltpol untereinander verbunden werden.

Vorzugsweise setzt sich das Grundkontaktfeld aus Grundkontaktstreifen, -segmenten oder -modulen zusammen. Diese einzelnen Bereiche können in sich autarke Einheiten bilden, die auch die gesamte Peripherieelektronik aufweisen, so daß bei einem Ausfall eines Bereichs ein einfacher Ersatz durch Austausch möglich ist. Vorzugsweise sind die Kontakte als Kontaktflächen (pads) einer das Grundkontaktfeld bildenden Grundplatte ausgebildet. Die pads bilden ein Flächenraster, wobei sie voneinander durch Isolierzonen elektrisch getrennt sind. Diese Isolierzonen können auch als erhabene Isolierstege ausgebildet sein, so daß Vertiefungen ausgebildet werden, deren Grundflächen von den Kontaktflächen gebildet werden. Derartige Vertiefungen bieten der Kontaktierung des Prüflings dienenden Federkontaktstiften eine Ausrichtung, so daß die Berührung der zugehörigen Kontaktfläche stets sichergestellt ist.

Nach einem bevorzugten Ausführungsbeispiel der Erfindung ist vorgesehen, daß sich die Grundplatte aus Grundplattenstreifen zusammensetzt, die jeweils an quer zu diesen verlaufenden, eine Prüfelektronik aufweisenden Platinen befestigt sind, wobei integrierte Anschlußbahnen jedes Grundplattenstreifens direkt mit den integrierten Anschlußbahnen der zugehörigen Platine elektrisch verbunden sind. Jedem Grundplattenstreifen, der eine entsprechende Anzahl von Kontakten, insbesondere pads, aufweist, ist somit die zugehörige Peripherieelektronik zugeordnet. Diese befindet sich auf der genannten Platine. Die elektrischen Verbindungen zwischen Grundplattenstreifen und Platine sind ohne Zwischenschaltung von Kabeln direkt ausgebildet, indem - wie bereits erwähnt - die integrierten Leiterbahnen der Grundplatte direkt mit integrierten Leiterbahnen des Grundplattenstreifens verlötet sind. Vorzugsweise werden die pads von Leiterbahnfeldern gebildet.

Aufgrund der extrem großen Anzahl von pads pro Flächeneinheit ist der Grundplattenstreifen vorzugsweise als Mehrlagen-Leiterplatte (Multilayer-Platine) ausgebildet. Dies kann ebenfalls auch bei der die Prüfelektronik aufweisenden Platine der Fall sein.

Möglichst kurze Leitungsverbindungen lassen sich erzielen, wenn die Mikro-Relais auf den Platinen angeordnet sind.

Die Mikro-Relais können bevorzugt als SMD-Bauteile (surface mounted device) ausgebildet sein.

Zur Bereitstellung der Prüfsignale sind die Platinen mit dem Bus einer die Prüfspannungen beziehungsweise Prüfpotentiale erzeugenden Prüfgeneratorvorrichtung verbunden.

Ein besonders komplexer Aufbau läßt sich erzielen, wenn die Schalteinrichtung als Relaismatrix, insbesondere Mikro-Relaismatrix ausgebildet ist.

Zur Behebung von Fehlern oder Schaltungsänderungen sind Redundanz-Relais vorgesehen, die zu Reparaturzwecken beim Ausfall von Mikro-Relais hinzugenommen und/oder ausgeschlossen werden können. Auf diese Art und Weise lassen sich auch die bereits erwähnten Schaltungsänderungen durchführen.

Die Redundanz-Relais können ebenfalls als Mikro-Relais ausgebildet sein. Verzugsweise sind sie ebenfalls als Mikro-Relais-Umschalter ausgeführt.

Die Relais-Matrix wird bevorzugt von einem Adressdekoder angesteuert. Auf diese Art und Weise läßt sich mit nur wenigen Signalkanälen eine Vielzahl von Mikro-Relais betätigen.

Der Relais-Matrix können logische Schaltungen, insbesondere Speicherelemente, zugeordnet sein. Insbesondere ist es möglich, eine Zustandsspeichereinrichtung vorzusehen. Hierdurch läßt sich - zeitlich gestaffelt - ein bestimmtes Ansteuerungsmuster erzielen, so daß ein zeitlich genau definiertes Prüfprogramm ablaufen kann.

Um mehrere Prüfsignale einem einzigen Kontakt, insbesondere pad, zuführen zu können, sind mehrere diesem Kontakt zugeordnete Relais gleichzeitig oder zeitlich versetzt zu einander ein- beziehungsweise ausschaltbar. Durch Überlagerung der einzelnen Prüfsignale lassen sich dann besonders komplexe Prüfsignale dem Prüfling zuleiten.

Nach einem bevorzugten Ausführungsbeispiel der Erfindung sind mehrere Mikro-Relais in einem Relais-Matrix-Chip zusammengefaßt, das adressierbar von einem Decoder eines Prüfcomputers ansteuerbar ist.

Nach einer Weiterbildung der Erfindung ist vorgesehen, daß die einzelnen, das Grundkontaktfeld bildenden Kontaktstreifen, -segmente oder -module gegeneinander abgedichtet sind. Diese Abdichtung ermöglicht es, Prüflinge mittels Unterdruck am Grundkontaktfeld während der Prüfung zu halten. Zwischen Grundkontaktfeld und Prüfling wird also ein Vakuum beziehungsweise Unterdruckraum geschaffen. Die Abdichtung kann von einer verpressten Dichtung oder von vorzugsweise pastöser formbarer Abdichtmasse gebildet sein. Die formbare Abdichtmasse ist im noch nicht ausgehärteten Zustand streichfähig und kann so in die Bereiche zwischen die einzelnen Grundkontaktstreifen, -segmente oder -module eingebracht werden.

Nach einer anderen Weiterbildung der Erfindung sind mehrere, gleichzeitig schaltende, zueinander parallel liegende Kontakte eines oder mehrerer Mikro-Relais zur Bereitstellung eines entsprechend hohen Prüfstromes vorgesehen. Durch die Vielzahl der zueinander parallel liegenden Kontakte ist eine entsprechend große Strombelastung möglich, ohne daß die maximale Strombelastung der einzelnen Kontakte überschritten wird.

Ferner ist es möglich, daß das oder die Mikro-Relais auf einem Substrat angeordnet sind, das insofern mechanische Bauteile trägt. Gleichzeitig kann dieses Substrat jedoch auch Träger einer elektronischen Schaltung, insbesondere einer Gatterschaltung und/oder einer Ansteuerlogik sein, so daß ein und dasselbe Substrat sowohl mechanische als auch elektrische Aufgaben übernimmt.

Die Zeichnungen veranschaulichen die Erfindung anhand mehrerer Ausführungsbeispiele und zwar zeigt:

Figur 1    einen schematischen Schaltungsauszug der Prüfvorrichtung,

Figur 2    eine Variante des Schaltungsauszugs der Figur 1,

Figur 3    ein Schaltungsdetail der Prüfanordnung nach einem ersten Ausführungsbeispiel,

Figur 4    ein Schaltungsdetail der Prüfanordnung nach einem zweiten Ausführungsbeispiel

Figur 5    ein Schaltungsdetail der Prüfanordnung nach einem dritten Ausführungsbeispiel

Figur 6    ein Schaltungsdetail der Prüfanordnung nach einem vierten Ausführungsbeispiel

Figur 7    ein schematisches Blockdiagramm der Prüfvorrichtung

Figur 8    ein Grundplattenstreifen mit quer dazu angeordneter eine Prüfelektronik aufweisende Platine.

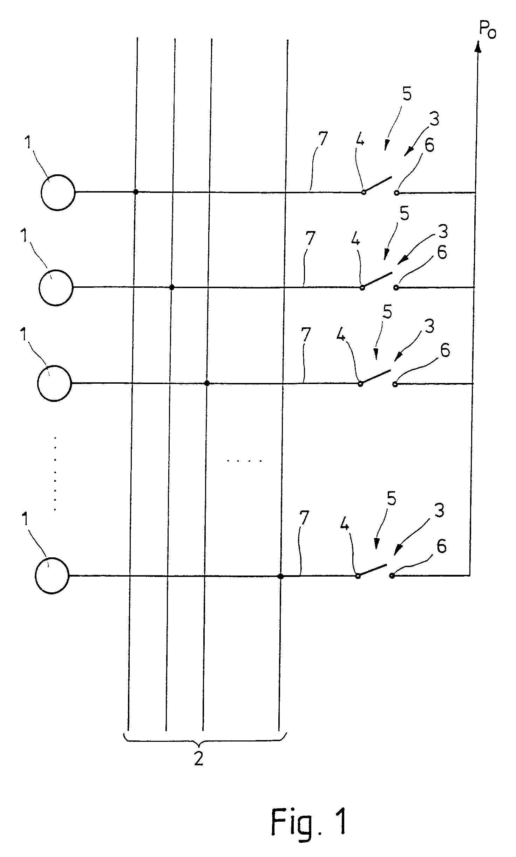

Das Ausführungsbeispiel der Figur 1 zeigt eine Vielzahl von Prüfgeneratoren 1, die mit einem Bus 2 verbunden sind. Jeder Prüfgenerator 1 steht mit einzelnen Schaltpolen 4 von Schalteinrichtungen 3 in Verbindung. Die Schalteinrichtungen 3 sind als Schalter von Relais, insbesondere Mikro-Relais 5 (nicht im einzelnen dargestellt) ausgebildet. Die anderen Schaltpole 6 sind als gemeinsame Schaltpole zu bezeichnen, da sie gemeinsam zu einem Kontakt $P_o$ führen. Mithin sind an die einzelnen Prüfgeneratoren 1 Prüfkanäle 7 angeschlossen, die über die Schalteinrichtungen 3 zu dem Kontakt $P_o$ führen. Die Prüfvorrichtung weist jedoch nicht nur einen, sondern eine Vielzahl, je nach Ausführung zum Beispiel zehntausende von Kontakten $P_o$ - $P_n$ auf, d.h., da jeder Kontakt P mit jedem Prüfgenerator 1 verbindbar sein soll, ist eine Anzahl von Schalteinrichtungen 3 notwendig, die sich aus dem Produkt der Kontaktzahl mit der Anzahl der Prüfgeneratoren 1 ergibt. Dies stellt einen immensen Aufwand dar.

Da die Funktion der Prüfvorrichtung nicht das Wesentliche der Erfindung ist, soll hier nur verständnishalber kurz auf die Arbeitsweise eingegangen werden. Die Schaltungsanordnung der Figur 1 ermöglicht es, mindest eine der von den Prüfgeneratoren 1 abgegebenen Prüfsignale durch Schließen einer Schalteinrichtung 3 zum Kontakt $P_o$ zu leiten. Von dort wird das Prüfsignal über Federkontaktstifte eines Adapters zum Prüfling geleitet. Sofern mehrere Schalteinrichtungen 3 angesteuert werden - deren Schalter also geschlossen werden - lassen sich einem Kontakt auch überlagerte Prüfsignale zuführen. Je nach Prüfling ist eine Vielzahl von Kontakten $P_o$ - $P_n$ vorgesehen. Insgesamt ist es insofern möglich, einem Prüfling, z.B. einer bestimmten Leiterplatte, die gewünschten Prüfsignale an individuellen Prüfpunkten zuzuführen, so daß ein Funktionstest oder ein In-Circuit-Test durchgeführt werden kann. Über weitere Federkontaktstifte, die ebenfalls zu Kontakten der Prüfvorrichtung führen, lassen sich die Ausgangssignale des Prüflings abnehmen und von einer (nicht näher dargestellten) Prüfeinrichtung auswerten. Das Prüfergebnis läßt erkennen, ob der Prüfling funktionsfähig ist oder Fehler aufweist.

Aufgrund des Einsatzes eines Stiftadapters, der die Verbindung zwischen den Kontakten P und den Prüfpunkten des Prüflings herstellt, ist ein besonders einfaches Kontaktieren möglich. Der Stiftadapter hat lediglich die Aufgabe, das Prüfpunktraster des Prüflings mit dem Kontaktraster der Prüfvorrichtung zu verbinden. Dies kann besonders einfach über Federstift-Adapter erfolgen, das heißt, Adapter, die zur Verbindung keine Kabel verwenden, sondern bei denen die Kontaktstifte direkt mit einem Ende gegen die Prüfpunkte des Prüflings und mit ihren anderen Enden gegen die Kontakte der Prüfvorrichtung treten. Die Kontakte der Prüfvorrichtung sind vorzugsweise auf einem Grundkontaktfeld in einem engen Raster angeordnet (Flächenraster). Sie sind insbesondere als sogenannte pads ausgebildet. Nach einer bevorzugten Ausbildungsform werden die pads von Leiterbahnflächen, insbesondere mit quadratischem oder kreisförmigem Grundriß, gebildet. Diese Leiterbahnflächen sind über integrierte Anschlußbahnen direkt mit den Schalteinrichtungen 3 verbunden, so daß besonders kurze und besonders einfach herzustellende Signalwege ausgebildet sind, die nur eine kleine Impedanz aufweisen und nicht zu einem "Übersprechen" auf Nachbarkanäle führen. Da die Schalteinrichtungen 3 erfindungsgemäß als Mikro-Relais 5 ausgebildet sind, können Sie aufgrund der kleinen Bauform der Mikro-Relais sehr nah an den Kontakten P angeordnet werden, so daß sich eine besonders kompakt aufgebaute und einfache Bauform ergibt. Es ist zum Beispiel möglich das oder die Mikro-Relais unterhalb des jeweils zugeordneten pad unterzubringen.

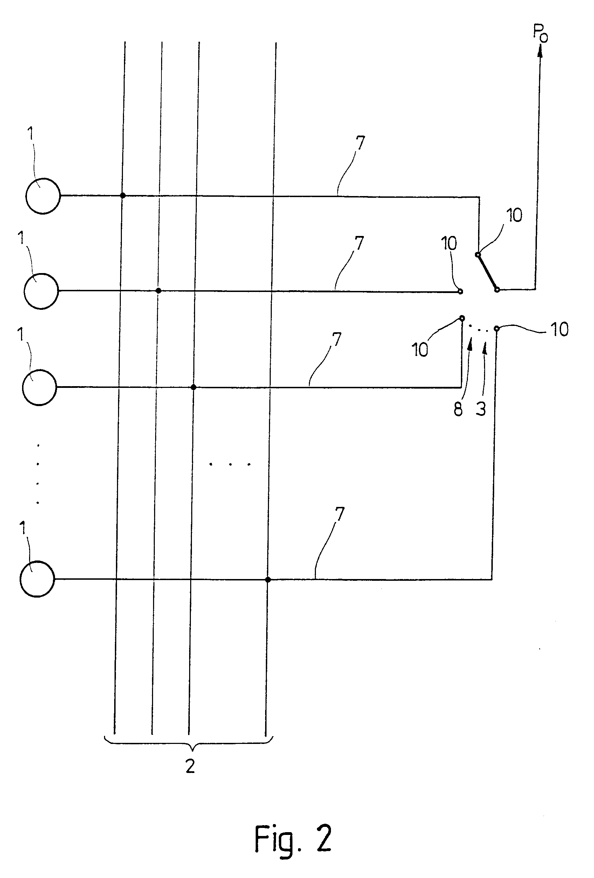

Das Ausführungsbeispiel der Figur 2 unterscheidet sich von dem der Figur 1 dadurch, daß die Schalteinrichtungen 3 nicht durch einfache Ein-Aus-Schalter der Mikro-Relais 5 ausgebildet sind, sondern von Mikro-Relais-Umschalter 8 gebildet werden. Hierzu steht der gemeinsame Schaltpol 9 jedes Mikro-Relais-Umschalters 8 mit seinem zugehörigen Kontakt P in Verbindung. Die den gemeinsamen Schaltpolen 9 zugeordneten einzelnen Schaltpole 10, die je nach Stellung des Schaltstücks des Mikro-Relais-Umschalters 8 mit dem gemeinsamen Schaltpol 9 verbunden werden können, sind an die einzelnen Prüfgeneratoren 1 angeschlossen. Auf diese Art und Weise können eine Vielzahl von einen Ein- bzw. Ausschalter aufweisende Mikro-Relais 5 durch einen einzigen Mikro-Relais-Umschalter 8 ersetzt werden. Dies vereinfacht die Gesamtschaltung der Prüfvorrichtung nochmals erheblich.

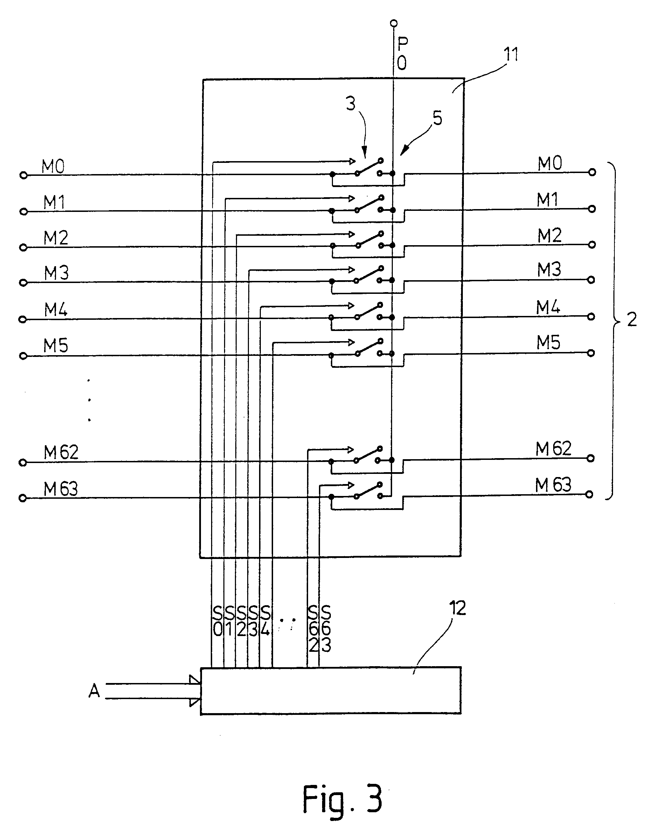

In den Figuren 3 - 6 soll im nachfolgenden auf unterschiedliche Schaltungsausbildungen eingegangen werden.

Die von den einzelnen Prüfgeneratoren 1 kommenden Prüfsignale M (im Ausführungsbeispiel M 0 - M 63) können als Prüfspannungen bzw. Prüfpotentiale oder Prüfströme ausgebildet sein. Möglich ist z.B. die Lieferung von Gleichspannungen, Wechselspannungen, Hochfrequenzsignalen, besonderen Spannungsformen (z.B. Sägezahn), dynamischen Größen usw.

Die Prüfsignale M werden in den Bus 2 eingespeist, so daß sie von dort verteilt, das heißt, den einzelnen Schalteinrichtungen 3, zugeführt werden können.

Die Figur 3 zeigt wiederum lediglich einen Schaltungsausschnitt, nämlich nur die Zuleitung der einzelnen Prüfsignale M über Schalteinrichtungen 3 zu einem Kontakt $P_o$. Die Schalteinrichtungen 3 sind als Relais-Matrix 11 ausgebildet. Diese weist einzelne Mikro-Relais 5 auf. Die Kontakte der einzelnen Mikro-Relais 5 lassen sich über Ansteuerleitungen S (S 0 - S 63) aktivieren. Die Ansteuerleitungen S führen zu einem Adressdecoder 12, der an Adressleitungen A angeschlossen ist. Eine über die Adressleitungen A codierte Ansteuerung des Adressdecoders führt dazu, daß die entsprechende Ansteuerleitung S aktiviert wird und das zugehörige Mikro-Relais 5 schaltet. Dadurch wird das zugehörige Prüfsignal M dem Kontakt P (im Ausführungsbeispiel der Figur 3 dem Kontakt $P_o$) zugeführt.

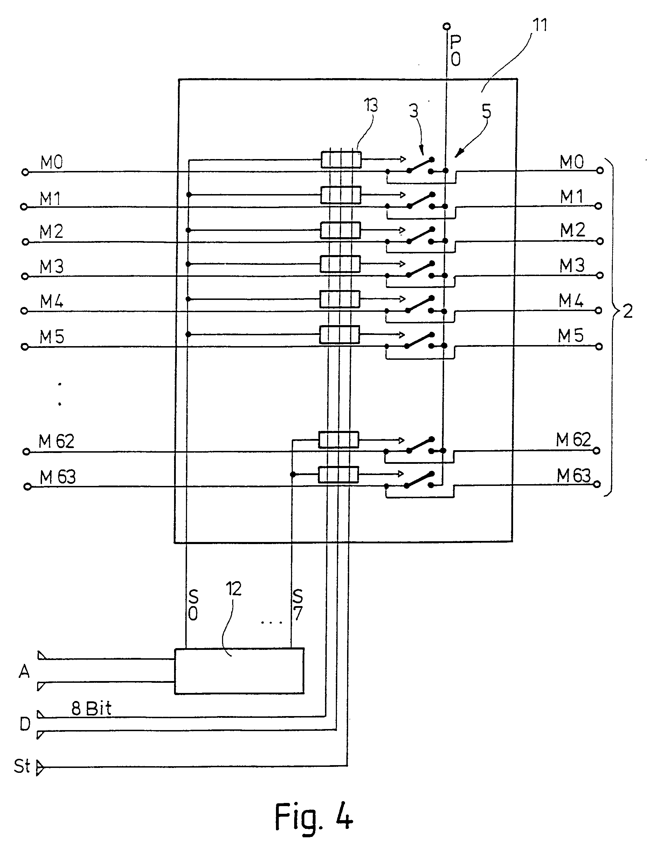

Die Figur 4 zeigt ein weiteres Ausführungsbeispiel, das sich gegenüber dem der Figur 3 darin unterscheidet, daß zusätzlich jedem Mikro-Relais 5 ein Registerspeicher 13 zugeordnet ist. Jeder Registerspeicher 13 ist über Ansteuerleitungen S mit dem Adressdecoder 12 verbunden. Überdies führen ein Datenbus D und Steuerleitungen St zu den einzelnen Registerspeichern 13. Durch das Anlegen einer Bitkombination an die Datenleitungen (Datenbus D, Steuerleitungen St für die Datenübertragung) und das Anlegen einer Adresse eines Byte-Registers an die Adressleitungen A kann ein entsprechendes Durchschaltmuster der einzelnen Mikro-Relais erzeugt werden, so daß die einzelnen Prüfsignale M oder Kombinationen von Prüfsignalen M in einem bestimmten Zeitmuster an den Kontakt $P_o$ (pad) angelegt werden. Die Registerspeicher 13 ermöglichen dabei eine Zustandsspeicherung.

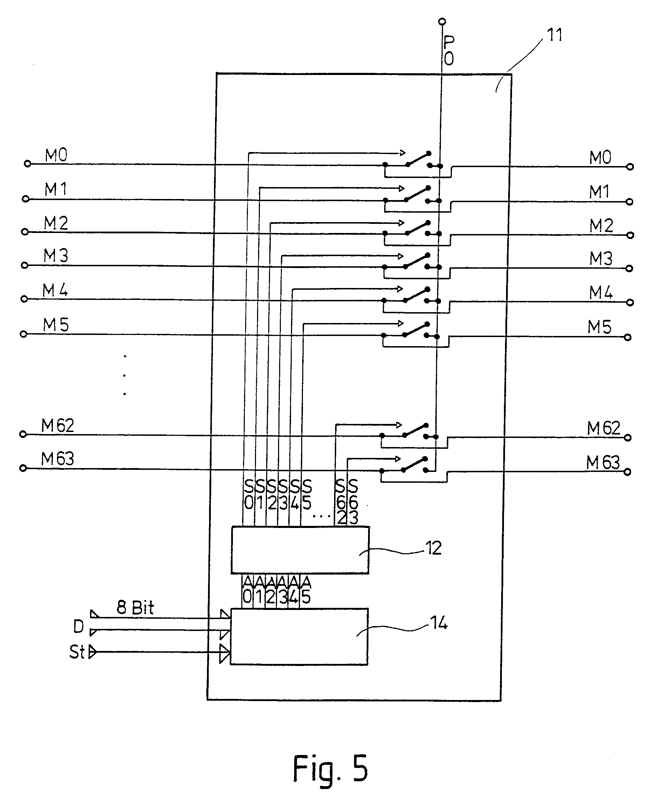

Ein weiteres Ausführungsbeispiel läßt - gemäß Figur 5 - eine Vereinfachung zu. Ebenfalls wie in der Figur 4 ist eine Relais-Matrix 11 mit Speicher vorgesehen. Allerdings besteht eine Reduzierung der Durchschaltmöglichkeit und zwar auf einen Prüfkanal pro Kontakt P, das heißt, es kann nur eins der Prüfsignale M auf den Kontakt $P_o$ geschaltet werden. Hierzu sind die einzelnen Adressleitungen A der Mikro-Relais 5 - die nicht mit Registerspeicher 13 gemäß dem Ausführungsbeispiel der Figur 4 versehen sind - einem Adressdecoder 12 zugeführt, der an ein Bit-Register 14 angeschlossen ist. Vorzugsweise handelt es sich um ein 6 Bit-Register. Das 6 Bit-Register 14 ist an einen Datenbus D und an Steuerleitung St einer Datenübertragung angeschlossen. Wird über den Datenbus D eine 6 Bit-Adresse (0......63) in das Datenregister geschrieben, so wird das korrespondierende Prüfsignal M durch Aktivierung des entsprechenden Mikro-Relais 5 auf den Kontakt P geschaltet.

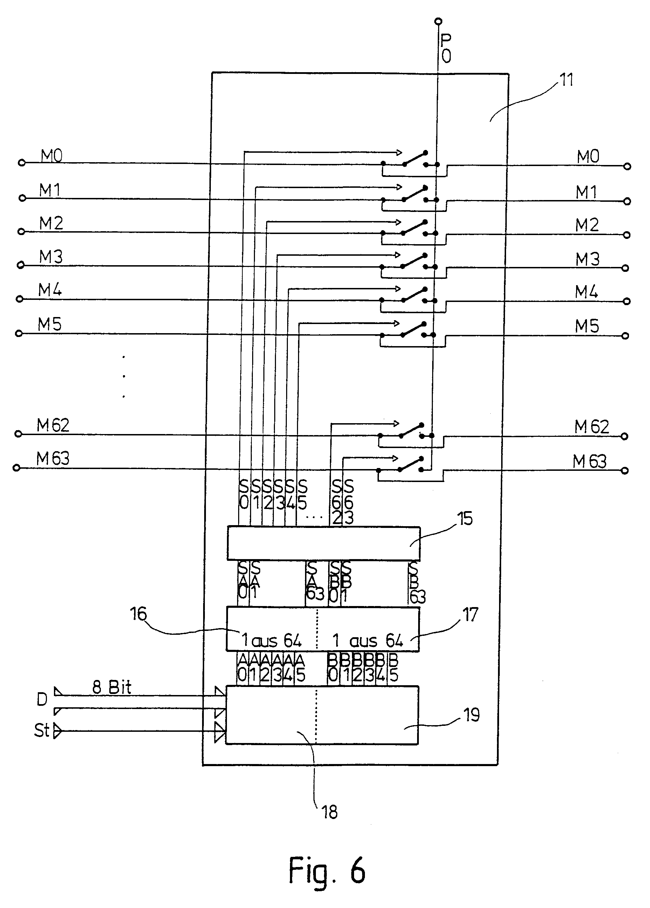

Die Figur 6 zeigt ein weiteres Ausführungsbeispiel, bei dem die Ansteuerleitungen S einer Oder-Verknüpfungsschaltung 15 zugeführt werden. Die Oder-Verknüpfungsschaltung 15 steht über 2 x 64 Adressleitungen (Ansteuerleitungen SA bzw. SB) mit einem ersten Adressdecoder 16 bzw. einem zweiten Adressdecoder 17 in Verbindung. Jedem Adressdecoder 16, 17 ist ein Bit-Register 18 bzw. 19 zugeordnet. Die Bit-Register 18 und 19 stehen mit einem Datenbus D sowie Steuerleitungen St in Verbindung. Vorzugsweise handelt es sich bei dem Ausführungsbeispiel der Figur 6 um 6 Bit-Register 18, 19 und 1 aus 64-Adressdecoder 16 bzw. 17. Aufgrund der Schaltungsausbildung der Figur 6 ist zwar eine Reduzierung der Durchschaltmöglichkeiten gegeben, jedoch können gleichzeitig zwei der unterschiedlichen Prüfsignale M auf den Kontakt $P_o$ geschaltet werden. Es besteht die sogenannte Möglichkeit des "Guarded-Line-Measurement". Wird über den Datenbus D eine 6 Bit-Adresse (0....63) in das Datenregister geschrieben, so wird der korrespondierende Meßkanal (Prüfsignal M) auf den Kontakt $P_o$ gelegt.

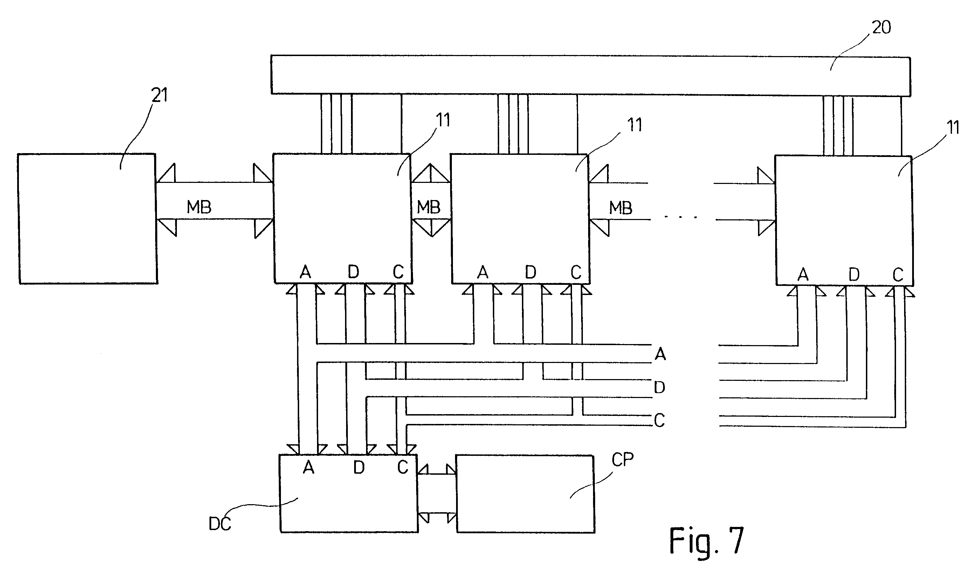

Die Figur 7 zeigt einen Gesamtüberblick über die erfindungsgemäße Prüfvorrichtung. Die einzelnen Kontakte ($P_o$...$P_n$) sind in einem Grundkontaktfeld 20 zusammengefaßt. Vorzugsweise weist das Grundkontaktfeld ein Flächenraster aus Kontaktflächen (pads) auf. Vorzugsweise ist das Grundkontaktfeld 20 nicht einstückig als Mehrlagen-Leiterplatte ausgebildet, sondern setzt sich aus einzelnen Mehrlagen-Leiterplattenbereichen zusammen, insbesondere aus Grundkontaktstreifen. Hierdurch ist es möglich, bei Ausfall oder bei Fehlern jeweils nur den entsprechenden Grundkontaktstreifen mit seiner zugehörigen Peripherieelektronik auszutauschen. Die einzelnen Kontakte P des Grundkontaktfeldes 20 sind an Relais-Matrizen angeschlossen. Die einzelnen Relais-Matrizen stehen über einen Meßbus MB in Verbindung, der zu einer Meßschaltung 21 führt. Ferner führt ein Datenbus D, ein Adressbus A und ein Kontrollbus C zu entsprechenden Eingängen bzw. Ausgängen der Relaismatrizen 11 und einem Decoder DC. Bei dem Decoder DC handelt es sich um den in den vorherigen Ausführungsbeispielen erwähnten Adressdecoder 12. Dieser steht über einen Datenbus mit einem Computer CP in Verbindung.

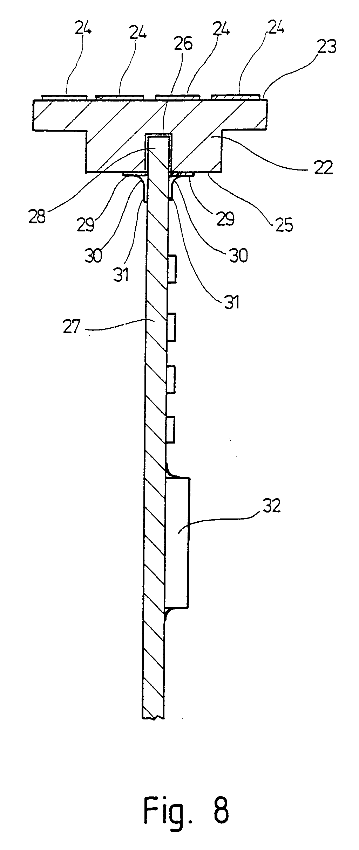

Die Figur 8 verdeutlicht den mechanischen Aufbau der erfindungsgemäßen Prüfvorrichtung. Gezeigt ist ein Grundkontaktstreifen 22, der auf seiner Oberseite 23 eine Vielzahl, in einem bestimmten Raster angeordnete Kontaktflächen 24 (pads) aufweist. Diese Kontaktflächen 24 sind als Leiterbahnabschnitte ausgebildet. Vorzugsweise besteht der Grundkontaktstreifen aus einem Mehrlagen-Leiterplattenstreifen (Multilayer). An seiner Unterseite 25 ist der Grundkontaktstreifen 22 mit einer Ausnehmung 26 versehen, in die eine sich quer zum Grundkontaktstreifen 22 erstreckende Platine 27 mit ihrem oberen Rand 28 eingesteckt und dort befestigt ist. Gegebenenfalls sind Grundkontaktstreifen 22 und Platine 27 miteinander verklebt. Hierzu kann beispielsweise ein entsprechendes Harz oder dgl. in die Ausnehmung 26 eingebracht werden. Die einzelnen Leiterbahnen des Grundkontaktstreifens 22 enden an der Unterseite 25 in reihenweise angeordneten Kontaktstreifen 29, die über Lötbrücken 30 mit entsprechenden Kontaktstreifen 31 der Platine 27 verbunden sind. Die Kontraktstreifen 29, 31 werden von Leiterbahnen der entsprechenden Bauteile gebildet. Auf der Platine 27 ist die Peripherieelektronik, also u.a. auch die in den Figuren 3 - 6 gezeigte Elektronik angeordnet. Insbesondere ist vorgesehen, daß sich die den einzelnen Kontaktflächen 24 zugeordneten Mikro-Relais 5 auf der entsprechenden Platine 27 befinden, so daß die elektrischen Verbindungen zwischen den Mikro-Relais 5 und den Kontakten (Kontaktflächen 24) sehr kurz sind und von integrierten Leiterbahnen gebildet werden. Sämtliche Mikro-Relais 5, die den Kontaktflächen 24 (pads) eines Grundkontaktstreifens 22 zugeordnet sind, lassen sich aufgrund der Mikrobauweise auf der zugehörigen Platine 27 anordnen. Nach einem bevorzugten Ausführungsbeispiel ist es möglich, daß die einzelnen Mikro-Relais 5 in sogenannten Relais-Matrix-Chips 33 zusammengefaßt sind, d.h., jede Platine 27 weist nur ein oder wenige Relais-Matrix-Chips 32 auf, wobei diese Bauteile die gesamte Komplexibilität der Schaltfunktionen ausüben können.

## Patentansprüche

1. Prüfvorrichtung, insbesondere für einen Funktionstest oder In-Circuit-Test von elektronischen Schaltungen (Prüflingen), insbesondere bestückten Leiterplatten, mit einer Vielzahl von unterschiedliche Prüfspannungen beziehungsweise Prüfpotentiale aufweisenden Prüfkanälen, die mit Prüfpunkten des Prüflings über Schalteinrichtungen verbindbar sind, dadurch gekennzeichnet, daß die Schalteinrichtungen (3) Mikro-Relais (5) aufweisen, deren einzelne Schaltpole (4, 10) mit den Prüfkanälen (7) und deren jedem Prüfkanal (7) zugehörige, gemeinsame Schaltpole (6, 9) über integrierte Anschlußbahnen mit im Raster angeordneten Kontakten (P; pads) eines Grundkontaktfelds (20) verbunden sind.

2. Prüfvorrichtung nach Anspruch 1, **dadurch gekennzeichnet**, daß die Mikro-Relais (5) als Mikro-Relais-Umschalter (8) ausgebildet sind.

3. Prüfvorrichtung nach einem der vorhergehenden Ansprüche, **dadurch gekennzeichnet**, daß für eine Verbindung der Prüfpunkte mit den Kontakten (P) ein Stift-Adapter, insbesondere Federstift-Adapter, zwischen dem Grundkontaktfeld (20), insbesondere einer Grundplatte, und dem Prüfling angeordnet ist.

4. Prüfvorrichtung nach einem der vorhergehenden Ansprüche, **dadurch gekennzeichnet**, daß sich das Grundkontaktfeld (20) aus Grundkontaktstreifen (22), -segmenten oder -modulen zusammensetzt.

5. Prüfvorrichtung nach einem der vorhergehenden Ansprüche, **dadurch gekennzeichnet**, daß die Kontakte (P) als Kontaktflächen (24; pads) eine das Grundkontaktfeld (20) bildenden Grundplatte ausgebildet sind.

6. Prüfvorrichtung nach einem der vorhergehenden Ansprüche, **dadurch gekennzeichnet**, daß sich die Grundplatte aus Grundplattenstreifen zusammensetzt, die jeweils an quer zu diesen verlaufenden, eine Prüfelektronik aufweisende Platinen (27) befestigt sind, wobei integrierte Anschlußbahnen jedes Grundplattenstreifens direkt mit integrierten Anschlußbahnen der zugehörigen Platinen (27) elektrisch verbunden sind.

7. Prüfvorrichtung nach einem der vorhergehenden Ansprüche, **dadurch gekennzeichnet**, daß die Grundplatte bzw. die Grundplattenstreifen und die Platinen (27) als Mehrlagen-Leiterplatten (Multilayer) ausgebildet sind.

8. Prüfvorrichtung nach einem der vorhergehenden Ansprüche, **dadurch gekennzeichnet**, daß die Mikro-Relais (5) auf den Platinen (27) angeordnet.

9. Prüfvorrichtung nach einem der vorhergehenden Ansprüche, **dadurch gekennzeichnet**, daß die Mikro-Relais (5) als SMD-Bauteile (surface mounted device) ausgebildet sind.

10. Prüfvorrichtung nach einem der vorhergehenden Ansprüche, **dadurch gekennzeichnet**, daß die Platinen (27) mit dem Bus einer die Prüfspannungen beziehungsweise die Prüfpotentiale erzeugenden Prüfgeneratorvorrichtung verbunden sind.

11. Prüfvorrichtung nach einem der vorhergehenden Ansprüche, **dadurch gekennzeichnet**, daß die Schalteinrichtungen (3) als Relaismatrix (11), insbesondere Mikro-Relaismatrix, ausgebildet sind.

12. Prüfvorrichtung nach einem der vorhergehenden Ansprüche, **gekennzeichnet durch** Redundanz-Relais, die zu Reparaturzwecken beim Ausfall von Mikro-Relais (5) oder Schaltungsänderungen hinzugenommen und/oder ausgeschlossen werden.

13. Prüfvorrichtung nach einem der vorhergehenden Ansprüche, **dadurch gekennzeichnet**, daß die Redundanz-Relais als Mikro-Relais (5), insbesondere als Mikro-Relais-Umschalter (8), ausgebildet sind.

14. Prüfvorrichtung nach einem der vorhergehenden Ansprüche, **dadurch gekennzeichnet**, daß die Relais-Matrix (11) von einem Adressdecoder (12, 16, 17) ansteuerbar ist.

15. Prüfvorrichtung nach einem der vorhergehenden Ansprüche, **dadurch gekennzeichnet**, daß der Relais-Matrix (11) logische Schaltungen, insbesondere Speicherelemente (Registerspeicher 13), zugeordnet sind.

16. Prüfvorrichtung nach einem der vorhergehenden Ansprüche, **dadurch gekennzeichnet**, daß jedem Relais der Relais-Matrix (11) eine Zustandsspeicher-Einrichtung zugeordnet ist.

17. Prüfvorrichtung nach einem der vorhergehenden Ansprüche, **dadurch gekennzeichnet**, daß mehrere, einem Kontakt (P) zugeordnete Relais (Mikro-Relais 5) gleichzeitig oder zeitlich versetzt zueinander ein- bzw. ausschaltbar sind.

18. Prüfvorrichtung nach einem der vorhergehenden Ansprüche, **dadurch gekennzeichnet**, daß die einzelnen, das Grundkontaktfeld (20) bildenden Grundkontaktstreifen (22), -segmente oder -module gegeneinander abgedichtet sind.

19. Prüfvorrichtung nach Anspruch 18, **dadurch gekennzeichnet**, daß die Abdichtung von einer verpressten Dichtung oder von formbarer Abdichtmasse gebildet ist.

20. Prüfvorrichtung nach einem der vorhergehenden Ansprüche, **gekennzeichnet durch** mehrere, gleichzeitig schaltende, zueinander parallel liegende Kontakte eines oder mehrere Mikro-Relais (5) zur Bereitstellung eines entsprechend hohen Prüfstroms.

21. Prüfvorrichtung nach einem der vorhergehenden Ansprüche, **gekennzeichnet durch** ein das oder die Mikro-Relais (5) aufnehmendes Substrat, das ebenfalls Träger einer elektronischen Schaltung, insbesondere einer Gatterschaltung und/oder einer Ansteuerlogik, ist.

Fig. 1

Fig. 2

Fig. 3

Fig. 4

Fig. 5

Fig. 6

Fig. 7

Fig. 8